# EUROPEAN PATENT APPLICATION

(11) **EP 4 749 389 A1**
(43) Date of publication of application: **27.05.2026**
(21) Application number: 25214566.9
(22) Date of filing: 10.11.2025
(51) Int. Cl.: G05F 1/56, G01R 27/26

(54) **PIN LIFT DETECTION COMPENSATION IN LOW DROPOUT (LDO) REGULATORS**

(30) Priority: 21.11.2024 US 202418954676
(71) Applicant: NXP USA, Inc., Austin, TX 78735 (US)
(72) Inventor: Ahmed, Hamada, 5656AG Eindhoven (NL); Romo Torres, Joaquin Alberto, 5656AG Eindhoven (NL); Jandu, Jaswinder Singh, 5656AG Eindhoven (NL); Pigott, John, 5656AG Eindhoven (NL)
(74) Representative: Krott, Michel

(57) **Abstract**

Systems and methods for pin lift detection compensation in Low Dropout (LDO) regulators. In an illustrative, non-limiting embodiment, a System-On-Chip (SoC) may include: a circuit; and an LDO regulator coupled to the circuit, where the LDO includes a transistor having a first terminal coupled to a first voltage rail and a second terminal coupled to the circuit, where the second terminal is configured to receive a probe current produced from a second voltage rail, and where the first voltage rail is coupled to a compensating current source configured to draw a compensating charge equal to or greater than a charge imparted upon the second terminal by the probe current.

## Description

### Field

This disclosure relates generally to electronic circuits, and more specifically, to systems and methods for pin lift detection compensation in Low Dropout (LDO) regulators.

### Background

A Low Dropout (LDO) regulator is a type of voltage regulator that can maintain a constant output voltage even when the input voltage is very close to the output voltage. LDO regulators are widely used in electronic circuits to provide stable and noise-free power to sensitive components. They are generally valued for their simplicity, low noise, and ability to operate with a small difference between input and output voltages.

In many applications, particularly in critical systems, it may be important to ensure the reliability and stability of the power supply provided by LDO regulators. To that end, on-demand, functional safety tests have been developed to detect and respond to faults in a way that prevents hazardous situations.

### Brief Description of the Drawings

The present disclosure is illustrated by way of example and is not limited by the accompanying figures, in which like references indicate similar elements. Elements in the figures are illustrated for simplicity and clarity and have not necessarily been drawn to scale.
FIG. 1 is a diagram of an example of an electronic device, according to some embodiments.
FIG. 2 is a diagram of an example of a System-on-Chip (SoC) having a Low Dropout (LDO) regulator as part of an electronic device, according to some embodiments.
FIG. 3 is a diagram of an example of a pin lift detection compensation circuit in an LDO regulator, according to some embodiments.
FIG. 4 is a flowchart of a method for pin lift detection compensation in an LDO regulator, according to some embodiments.
FIG. 5 is a schematic of an example of a circuit configured to implement pin lift detection compensation in LDO regulators, according to some embodiments.

### Detailed Description

Low Dropout (LDO) regulators play a significant role in modern System-on-Chip (SoC) architectures by providing stable and noise-free power to sensitive components. LDOs maintain a constant output voltage even when the input voltage is close to the output voltage, which is important for the reliable operation of various integrated circuits within an SoC. The ability of LDO regulators to operate with a small difference between input and output voltages makes them particularly useful in power-sensitive applications, where efficiency and minimal power loss are important.

In SoC architectures, LDO regulators are often used to supply power to analog and digital circuits, ensuring that these circuits receive a clean and stable voltage. This is particularly important for components such as microprocessors, memory devices, and communication interfaces, which require precise voltage levels to operate correctly. By providing a stable power supply, LDO regulators help to minimize noise and voltage fluctuations, which can otherwise lead to errors and instability in the SoC's operation.

Furthermore, LDO regulators contribute to the overall power management strategy of an SoC by enabling efficient power distribution and regulation. They can be used to create multiple voltage domains within the SoC, allowing different components to operate at their optimal voltage levels. This may not only improve the performance and reliability of the SoC but also enhance energy efficiency, which is a typical consideration in battery-powered and portable devices.

On-demand testing (*e.g*., "functional testing") is crucial in modern SoC architectures to ensure the reliability and stability of integrated circuits, including LDO regulators. In that regard, pin lift detection is an important aspect of functional testing for LDO regulators within SoC architectures. The term "pin lift," as used herein, refers to a condition where a required load compensation capacitor becomes disconnected from the output pin of an LDO regulator. This capacitor is configured to maintain the stability and performance of the LDO regulator by filtering out noise and stabilizing the output voltage. As a result, detecting pin lift is particularly important in functional safety systems, where the absence of the capacitor can lead to instability and potential failure of the LDO regulator, affecting the entire SoC's operation.

Conventional methods for testing an LDO regulator's operation with respect to pin lift involve pulsing a probe current into the pin under test, which is the output of the LDO regulator connected to a load and capacitor in a normal state. The voltage change at the pin is then observed to determine the presence or absence of the external filtering capacitor. If the capacitor is present, the voltage change is minimal, indicating proper operation. If the capacitor is absent, the voltage rises significantly, indicating a fault condition. This method helps ensure that the LDO regulator operates correctly and maintains the stability of the power supply in functional safety systems, which is vital for the reliable operation of SoC architectures.

The traditional approach, however, leads to output voltage excursions and unwanted current delivery, especially when the operating voltage is low. Existing solutions often fail to accurately generate the required currents under low voltage conditions, resulting in potential instability and undesired current flow.

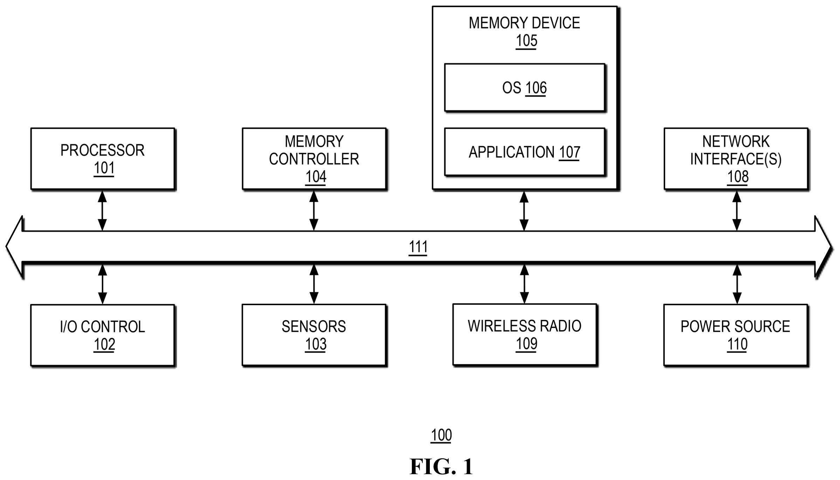

To address these, and other concerns, systems and methods described herein provide reliable pin lift detection without causing voltage fluctuations or delivering unwanted current to the input pin of an LDO regulator. Moreover, these systems and methods may be implemented in any SoC device-an example of which is illustrated FIG. 1.

FIG. 1 shows a non-limiting example of electronic device 100 where systems and methods for pin lift detection compensation in LDO regulators may be implemented. In various embodiments, device 100 may be integrated with electronic circuitry, microprocessors, microcontrollers, memory, input output (I/O) logic control, communication interfaces and components, as well as other hardware, firmware, or software. Moreover, one or more components of device 100 may be part of an SoC, or the like.

Device 100 includes processor 101 (*e.g.*, a controller, a microcontroller, a digital signal processor, etc.) configured to execute program instructions stored in memory device 105 for implementing various systems and methods described herein. Processor 101 may include components of an integrated circuit, programmable logic device, a logic device formed using one or more semiconductors, and other implementations in silicon or hardware.

In some cases, processor 101 may include two domains: (i) a low-power microprocessor, core, or domain, and (ii) a high-power microprocessor, core, or domain. The high-power microprocessor may execute computationally intensive operations, whereas the low-power microprocessor may manage simpler processes, such as detecting inputs from one or more sensors. The low-power processor may also wake or initialize the high-power processor for computationally intensive processes. More generally, processor 101 may include any number of such domains.

In device 100, data bus 111 couples its various components and enables data communication between those components. Data bus 111 may be implemented as any suitable combination of one or more bus structures or bus architectures. Device 100 also includes power source 110, such as a battery or an AC-DC power supply.

Sensors 103 may be implemented to detect various properties such as acceleration, temperature, humidity, water, supplied power, proximity, external motion, device motion, sound signals, ultrasound signals, light signals, fire, smoke, carbon monoxide, Global-Positioning-Satellite (GPS) signals, radio frequency (RF), other electromagnetic signals or fields, or the like. As such, sensors 103 may include any one or a combination of temperature sensors, humidity sensors, hazard-related sensors, other environmental sensors, accelerometers, microphones, optical sensors up to and including cameras (*e.g*., charged coupled-device or video cameras, active or passive radiation sensors, GPS receivers, and RF identification (ID) detectors).

Memory controller 104 and memory device 105 may implement any type of nonvolatile memory or other suitable electronic storage device. Device 100 may include various firmware or software, such as Operating System (OS) 106 maintained as computer executable instructions in memory 105 and executed by processor 101. Moreover, application 107 may include a distance estimation application that implements various aspects of the systems and methods described herein.

Input-output (I/O) control 102 may be configured to receive input from a user or provide information to the user. For example, I/O control 102 may also include mechanical or virtual components that respond to a user input. For example, the user can mechanically move a sliding or rotatable component, or the motion along a touchpad may be detected, and may correspond to a setting of device 100.

Device 100 includes network interfaces 108, such as a mesh network interface for communication with other devices in a wireless mesh network, and an external network interface for network communication, such as via the Internet. Wireless radio system 109 may be used for wireless communication with other devices via network interface 108 and for multiple, different wireless communications systems. For instance, radio system 109 may include a radio device, antenna, and chipset implemented for any given wireless communications technology, such as, for example, Wi-Fi, BLUETOOTH (BT), BT Low-Energy (BLE), Mobile Broadband, point-to-point IEEE 802.15.4, etc.

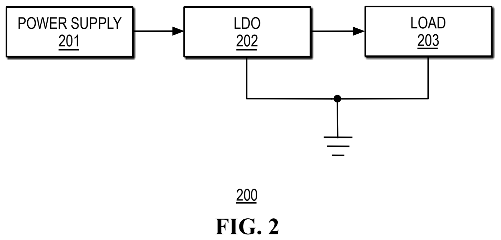

FIG. 2 is a diagram of an example of SoC 200 having LDO regulator 202 as part of electronic device 100. As shown, SoC 200 may include power supply 201 coupled to LDO regulator 202 and configured to provide a supply voltage thereto. In response, LDO regulator 202 is configured to provide a regulated output voltage (or simply "output voltage") to load 203. In various implementations, load 203 may include a processor, a memory device, a communication interface, a sensor, or an analog circuit, or the like.

In some cases, LDO regulator 202 may generate one output voltage; in other implementations, however, LDO regulator 202 may be configured to generate two or more output voltages.

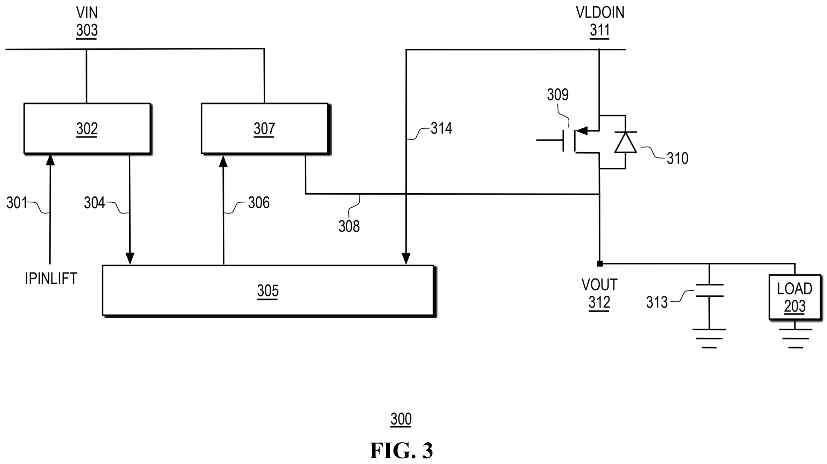

FIG. 3 is a diagram of an example of pin lift detection compensation circuit 300 in LDO regulator 202. As shown, circuit 300 comprises first current mirror 302 powered by first voltage rail (VIN) 303. First current mirror 302 may be configured to receive probe current 301 (*e.g*., in response to a control signal issued by an on-demand test process) and to output first amplified current 304.

Second current mirror and current source 305 may receive first amplified current 304 and produces second amplified current 306. Third current mirror 307, also coupled to VIN 303, may receive second amplified current 306 and produce amplified probe current 308, which is may then be applied to output terminal 312 of pass transistor 309.

Pass transistor 309 may be coupled to another voltage rail 311 (VLDOIN) and it produces a regulated output at output terminal 312. Diode 310 represents a parasitic body diode inherent to pass transistor 309. As such, pass transistor 309 may ordinarily provide a regulated voltage to load 203 across coupling capacitor 313.

In some embodiments, VLDOIN 311 may also be coupled to a compensating current source within second current mirror and current source 305, such that the compensating current source is configured to draw a compensating charge or current 314 equal to or greater than a charge or current imparted upon output terminal 312 or capacitor 313 due to the application of amplified probe current 308.

In various implementations, VIN 303 may be greater than VLDOIN 311. Amplified probe current 308 is generated from VIN 303 and injected into output terminal 312 to test the presence of capacitor 313. By observing a voltage change at output terminal 312, circuit 300 may determine whether the capacitor is connected or disconnected. In some cases, injection of amplified probe current 308 may be synchronized with compensating current 314 drawn from VLDOIN 311, for example, by triggering both events to the same control signal, simultaneous control signals, or concurrent control signals.

In some cases, pass transistor 309 may be a p-channel metal-oxide-semiconductor (PMOS) transistor, such that its source terminal is couped to VLDOIN 311 and drain terminal to output terminal 312. In other cases, however, pass transistor 309 may be an n-channel MOS (NMOS) transistor.

In an implementation, for example, probe current 301 may include a pulsed (*e.g.*, 0.1 ms) current of 1 µA, first amplified current 304 may be 5 µA, second amplified current 306 may be 10 µA, and amplified probe current 308 may be 100 µA. Meanwhile, compensating current source 305 may be configured to drain compensating current 314 in the amount of 100 µA or more (*e.g*., 150 µA) simultaneously with probe current 301.

Circuit 300 may provide pin-lift detection that effectively prevents unwanted voltage excursions on VLDOIN 311, promoting stability and reliability of the entire system, at least in part, by flagging faults.

Third current mirror 307 delivers current 308 to output terminal 312 (VOUT), and if there is a fault, then current may flow from output terminal 312 through diode 310 to VLDOIN 311. To avoid a net delivery of current to VLDOIN 311, current source 305 and wire 314 consume a greater or equal current so that the net current (*i.e.*, the current in diode 310 minus the current in wire 314) is negative. As such, circuit 300 may avoid delivering unwanted current to VLDOIN 311 under fault conditions, including when capacitor 313 is disconnected.

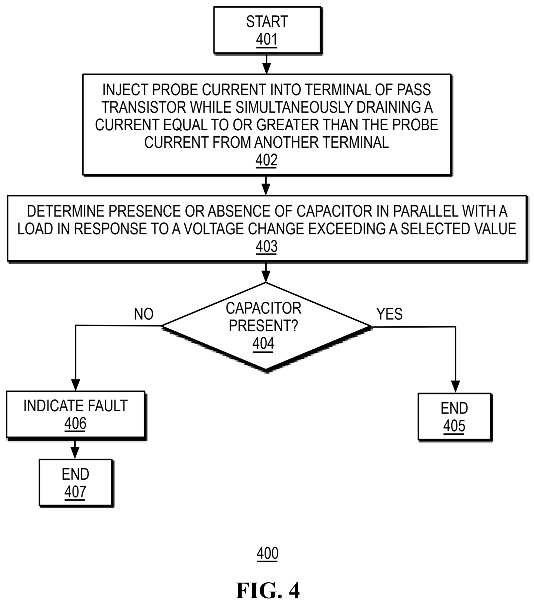

FIG. 4 is a flowchart of method 400 for pin lift detection compensation in LDO regulator 202. In various embodiments method 400 may be performed, at least in part, using circuit 300. Particularly, method 400 starts at step 401.

At step 402, method 400 may include injecting a probe current (*e.g*., probe current 301) into a terminal of pass transistor 309 (*e.g*., the drain terminal, if 309 is a PMOS transistor) while simultaneously draining a current (*e.g*., compensating current 314) equal to or greater than the probe current from another terminal (*e.g*., the source terminal, if PMOS). At step 403, method 400 may determine the presence or absence of capacitor 313 in parallel with load 203 in response to a voltage change exceeding a selected value.

At step 404, if capacitor 313 is present, method 400 passes to 405 where it ends. However, if capacitor 313 is absent, at step 406 method 400 may indicate a fault or error before method 400 ends at step 407.

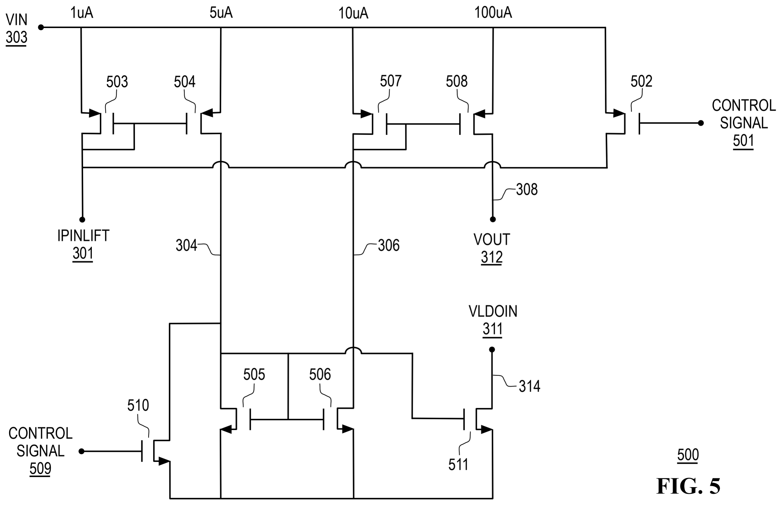

FIG. 5 is a schematic of an example of circuit 500 for pin lift detection compensation in in LDO regulator 202. In some implementations, circuit 500 may be used to implement pin lift detection compensation circuit 300 of FIG. 3. In this example, first current mirror 302 is implemented by transistors 503 and 504, second current mirror 305 is implemented by transistors 505 and 506, compensating current source is implemented by transistor 511, and third current mirror 307 is implemented by transistors 507 and 508.

The gate terminal of transistor 502 may receive control signal 501 to enable the amplification of probe current 301 into current 308 concurrently with the application of control signal 509 to the gate terminal of transistor 510, which in turn allows compensation current 314 (*e.g*., 100 µA) to flow through transistor 511 from VLDOIN 311. First amplified current 304 and second amplified current 306 are also shown.

In some cases, control signals 501 and 509 may be the same signal, but of opposite polarity (*e.g*., a high control signal 509 disables transistor 510, whereas a high control signal 501 enables transistor 502). In other cases, control signals 501 and 509 may be distinct, yet synchronized, simultaneous, or concurrent (*e.g*., pulse) signals.

In circuit 500, transistors 502-504, 507, and 508 may be PMOS transistors whereas transistors 505, 506, 510, and 511 may be NMOS transistors. In other embodiments, however, circuit 500 may include different types of transistors or transistors configurations.

As such, systems, and methods for pin lift detection compensation in LDO regulators are described. In an illustrative, non-limiting embodiment, an SoC may include: a circuit; and an LDO coupled to the circuit, where the LDO includes a transistor having a first terminal coupled to a first voltage rail and a second terminal coupled to the circuit, where the second terminal is configured to receive a probe current produced from a second voltage rail, and where the first voltage rail is coupled to a compensating current source configured to draw a compensating charge equal to or greater than a charge imparted upon the second terminal by the probe current.

In some cases, the voltage of the second voltage rail may be greater than a voltage of the first voltage rail. The compensating current source may be configured to operate in conjunction with application of the probe current. The compensating current source may be activated in response to a control signal, and the probe current may be received in response to at least one of: the control signal, or another control signal simultaneous with the control signal.

Moreover, the second terminal may be coupled to an external capacitor in parallel with the circuit. The current source may be configured to draw a current equal to or greater than the probe current or an amplified probe current. The probe current or an amplified probe current may be applied to the second terminal as part of an on-demand test of the SoC.

In various embodiments, the circuit may include at least one of: a processor, a memory device, a communication interface, a sensor, or an analog circuit. The SoC may be configured to: monitor a voltage change at the second terminal to determine the presence or absence of a capacitor; and indicate a fault condition if the voltage change meets or exceeds a selected value.

In another illustrative, non-limiting embodiment, an LDO regulator may include: a transistor having a first terminal coupled to a first voltage rail and a second terminal coupled to the circuit, where the second terminal is coupled to a load, and where the second terminal is configured to receive a probe current produced from a second voltage rail; and a current source coupled to the first voltage rail, where the current source is configured to draw a current equal to or greater than the probe current.

For example, a voltage of the second voltage rail may be greater than a voltage of the first voltage rail. The compensating current source may be activated in response to a control signal, and the probe current may be received in response to at least one of: the control signal, or another control signal simultaneous with the control signal. The LDO regulator may also include a capacitor coupled in parallel with the circuit, where the current source is configured to draw a compensating charge equal to or greater than a charge otherwise imparted by the probe current.

The probe current may be applied to the second terminal as part of an on-demand test of the LDO. Furthermore, the load may include at least one of: a processor, a memory device, a communication interface, a sensor, or an analog circuit.

In yet another illustrative, non-limiting embodiment, a method may include monitoring a voltage change at a terminal of a pass transistor of an LDO regulator to determine the presence or absence of a capacitor coupled in parallel with a load, at least in part, by injecting a probe current into the terminal while simultaneously draining a current equal to or greater than the probe current from another terminal; and indicating a fault condition if the voltage change exceeds a selected value.

The probe current may be produced from a voltage rail, and a voltage of the voltage rail may be greater than the voltage of the other terminal. The injection of the probe current may be in response to a control signal, and the draining may be activated in response to at least one of: the control signal, or another control signal simultaneous with the control signal.

The load may include at least one of: a processor, a memory device, a communication interface, a sensor, or an analog circuit. The fault condition may be part of an on-demand test of an SoC.

In many implementations, systems and methods described herein may be incorporated into a wide range of electronic devices including, for example, computer systems or Information Technology (IT) products; consumer devices or appliances; scientific instrumentation; industrial robotics; medical or laboratory electronics; transportation vehicles such as automobiles, buses, trucks, trains, watercraft, aircraft, etc.; military equipment, etc.

For sake of brevity, conventional techniques have not been described in detail herein. Furthermore, the connecting lines shown in the various figures contained herein have been intended to illustrate relationships (e.g., logical) or physical couplings (e.g., electrical) between the various elements. It should be noted, however, that alternative relationships and connections may be used in other embodiments. Moreover, circuitry described herein may be implemented either in silicon or another semiconductor material or alternatively by software code representation thereof.

Although various systems and methods are described herein with reference to specific embodiments, modifications and changes may be made without departing from the scope of the present disclosure, as set forth in the claims below. Accordingly, the specification and figures are to be regarded in an illustrative rather than a restrictive sense, and all such modifications are intended to be included. Any benefits, advantages, or solutions to problems that are described herein regarding specific embodiments are not intended to be construed as a critical, required, or essential feature or element of any or all the claims.

Reference is made herein to "configuring" a device or a device "configured to" perform some operation(s). This may include selecting predefined logic blocks and logically associating them. It may also include programming computer software-based logic of a retrofit control device, wiring discrete hardware components, or a combination thereof. Such configured devices are physically designed to perform the specified operation(s).

Unless stated otherwise, terms such as "first" and "second" are used to arbitrarily distinguish between the elements such terms describe. Thus, these terms are not necessarily intended to indicate temporal or other prioritization of such elements. The terms "coupled" or "operably coupled" are defined as connected, although not necessarily directly, and not necessarily mechanically. The terms "a" and "an" are defined as one or more unless stated otherwise. The terms "comprise" (and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A System-On-Chip (SoC), comprising:
a circuit; and
a Low Dropout (LDO) regulator coupled to the circuit, wherein the LDO regulator comprises a transistor having a first terminal coupled to a first voltage rail and a second terminal coupled to the circuit, wherein the second terminal is configured to receive a probe current produced from a second voltage rail, and wherein the first voltage rail is coupled to a compensating current source configured to draw a compensating charge equal to or greater than a charge imparted upon the second terminal by the probe current.

2. The SoC of claim 1, wherein a voltage of the second voltage rail is greater than a voltage of the first voltage rail.

3. The SoC of claim 1 or 2, wherein the compensating current source is configured to operate in conjunction with application of the probe current.

4. The SoC of any preceding claim, wherein the compensating current source is activated in response to a control signal, and wherein the probe current is received in response to at least one of: the control signal, or another control signal simultaneous with the control signal.

5. The SoC of any preceding claim, further wherein the second terminal is coupled to an external capacitor in parallel with the circuit.

6. The SoC of any preceding claim, wherein the compensating current source is configured to draw a current equal to or greater than the probe current or an amplified probe current.

7. The SoC of any preceding claim, wherein the probe current or an amplified probe current is applied to the second terminal as part of an on-demand test of the SoC.

8. The SoC of any preceding claim, wherein the circuit comprises at least one of: a processor, a memory device, a communication interface, a sensor, or an analog circuit.

9. The SoC of any preceding claim, wherein the SoC is configured to:
monitor a voltage change at the second terminal to determine a presence or absence of a capacitor; and
indicate a fault condition if the voltage change meets or exceeds a selected value.

10. A method, comprising:
monitoring a voltage change at a terminal of a pass transistor of a Low Dropout (LDO) regulator to determine a presence or absence of a capacitor coupled in parallel with a load, at least in part, by injecting a probe current into the terminal while simultaneously draining a current equal to or greater than the probe current from another terminal; and
indicating a fault condition if the voltage change exceeds a selected value.

11. The method of claim 10, wherein the probe current is produced from a voltage rail, and wherein a voltage of the voltage rail is greater than the voltage of the another terminal.

12. The method of claim 10 or 11, wherein injecting the probe current is in response to a control signal, and wherein the draining is activated in response to at least one of: the control signal, or another control signal simultaneous with the control signal.

13. The method of any one of claims 10 to 12, wherein the load comprises at least one of: a processor, a memory device, a communication interface, a sensor, or an analog circuit.

14. The method of any one of claims 10 to 12, wherein the fault condition is part of an on-demand test of a System-on-Chip (SoC).
